# EUROPÄISCHE PATENTSCHRIFT

(11) **EP 3 026 697 B1**
(45) Veröffentlichungstag und Bekanntmachung des Hinweises auf die Patenterteilung: **14.10.2020**
(21) Anmeldenummer: 14195319.0
(22) Anmeldetag: 28.11.2014
(51) Int. Cl.: H01L 21/67

(54) **Schweißvorrichtung zum Anschweißen einer Folie an einem Substrat**
Welding device for welding a film to a substrate
Dispositif de soudage destiné à souder une feuille sur un substrat

(43) Veröffentlichungstag der Anmeldung: 01.06.2016
(73) Patentinhaber: Mechatronic Systemtechnik GmbH, 9500 Villach (AT)
(72) Erfinder: Oremus, Alexander, 9500 Villach (AT)
(74) Vertreter: Müller, Thomas

(56) Entgegenhaltungen:
- WO-A1-2005/104221
- GB-A- 1 337 809
- GB-A- 1 536 428
- US-A1- 2003 062 116
- US-A1- 2005 205 204

## Beschreibung

Die vorliegende Erfindung betrifft zunächst eine Schweißvorrichtung zum Anschweißen einer Folie an einem Substrat. Weiterhin betrifft die Erfindung auch eine Bearbeitungsvorrichtung zum Anschweißen einer Folie an einem Substrat. Schließlich betrifft die Erfindung auch ein Verfahren zum Anschweißen einer Folie an einem Substrat.

Das Aufbringen beziehungsweise Anschweißen von Folien auf/an Substraten ist bereits seit langem bekannt und findet Anwendung in den unterschiedlichsten technischen Gebieten.

Ein solches technisches Gebiet, bei dem Folien auf Substrate aufgebracht werden, stellt die Herstellung und Bearbeitung von Substraten in Form von Wafern dar. Ein Wafer ist grundsätzlich eine kreisrunde oder viereckige Scheibe, auf der sich elektronische Bauelemente befinden.

Während der Bearbeitung solcher Wafer befinden sich diese in der Regel auf beziehungsweise in einer Bearbeitungsvorrichtung, die beispielsweise einen Bearbeitungstisch aufweisen kann. Der Bearbeitungstisch verfügt über eine Halteeinrichtung, auf der der Wafer während der Bearbeitung angeordnet ist, und auf der der Wafer, beispielsweise mittels Vakuum, angesaugt wird oder ist.

Während der Bearbeitung solcher Wafer ist nicht selten vorgesehen, dass diese, zumindest auf einer ihrer Oberflächen und zumindest zeitweilig, mit einer Folie abgedeckt werden, wobei diese Folie in der Regel auf den Wafer auflaminiert wird. Diese Folie erfüllt in manchen Anwendungen eine Schutzfunktion und ist insofern als Schutzfolie ausgebildet. Im weiteren Stadium der Bearbeitung der Wafer müssen diese Schutzfolien dann wieder entfernt werden. Dies geschieht in der Regel mittels einer dafür vorgesehenen Folien-Abziehvorrichtung. Die Folien-Abziehprozedur, die auch als Folien-Peeling-Prozedur bezeichnet werden kann, wird in der Regel in einer Weise durchgeführt, dass eine besondere Abziehfolie oder Peeling-Folie an die abzuziehende Schutzfolie angeschweißt wird. Anschließend wird die Abziehfolie mittels der Abziehvorrichtung gezogen, wobei die an der Abziehfolie angeschweißte Schutzfolie mit abgezogen wird.

Beim Anschweißen der Abziehfolie an die abzuziehende Schutzfolie kann das Problem auftreten, dass sich bei noch heißer und somit weicher Schweißverbindung die Abziehfolie von der Schutzfolie bei Beginn der Folien-Abziehprozedur ablöst und abreißt. Dieses Problem tritt insbesondere dann auf, wenn das Anschweißen der Abziehfolie an die Schutzfolie von unten erfolgt.

In der WO 2005/104221 A1 wird eine Lösung zum Anheften einer Folie beschrieben, bei welcher eine Folie an einem Substrat angeschweißt wird eine Kühleinrichtung in Form einer Kühlplatte zum Einsatz kommt.

Die Aufgabe der vorliegenden Erfindung besteht darin, eine Schweißvorrichtung für das Anschweißen von Folien bereitzustellen, mit der die vorgenannten Nachteile, insbesondere ein ungewolltes Ablösen beziehungsweise Abreißen der Abziehfolie oder ein Einreißen der Schweißverbindung verhindert werden kann, insbesondere dann, wenn die Folie von unten an das Substrat angeschweißt wird. Weiterhin sollen eine entsprechend verbesserte Bearbeitungsvorrichtung zum Anschweißen einer Folie an einem Substrat sowie ein entsprechend verbessertes Verfahren zum Anschweißen einer Folie an einem Substrat bereitgestellt werden.

Diese Aufgabe wird erfindungsgemäß gelöst durch die Schweißvorrichtung mit den Merkmalen gemäß dem unabhängigen Patentanspruch 1, die Bearbeitungsvorrichtung mit den Merkmalen gemäß dem Patentanspruch 9 sowie das Verfahren mit den Merkmalen gemäß dem unabhängigen Patentanspruch 11. Weitere Merkmale und Details der Erfindung ergeben sich aus den Unteransprüchen, der Beschreibung sowie den Zeichnungen.

Die vorliegende Erfindung basiert auf dem Grundgedanken, dass während der Anschweißprozedur, bei der eine Folie unter Erzeugung einer Schweißverbindung an ein Substrat angeschweißt wird, sehr zeitnah auch eine aktive Kühlung vorgenommen wird. Die dadurch erzielte Wirkung ist insbesondere dergestalt, dass der Anschweißprozess durch schnelles Abkühlen der Schweißverbindung oder der Schweißzone beschleunigt werden kann. Damit wird insbesondere sichergestellt, dass es nicht mehr zu dem unerwünschten Ablösen der Folie von dem Substrat kommen kann.

Gemäß dem ersten Aspekt der Erfindung wird eine Schweißvorrichtung zum Anschweißen einer Folie an einem Substrat bereitgestellt, die einen Schweißkopf aufweist. Die Schweißvorrichtung ist erfindungsgemäß dadurch gekennzeichnet, dass der Schweißkopf einen beheizbaren Schweißstempel zum Erzeugen einer Schweißverbindung und eine neben dem Schweißstempel vorgesehene Kühleinrichtung zum Kühlen der Schweißverbindung oder einer Schweißzone aufweist, dass der Schweißstempel eine gekrümmt verlaufende Kontur aufweist, dass die gekrümmt verlaufende Kontur insbesondere an eine Außenkante eines Substrats angepasst ist, an dass die Folie angeschweißt werden soll und dass die Kühleinrichtung eine oder mehrere Kühldüsen für ein Kühlmedium aufweist

Gemäß diesem ersten Aspekt der Erfindung wird eine Schweißvorrichtung zum Anschweißen einer Folie an einem Substrat bereitgestellt. Die Schweißvorrichtung ist derart bereitgestellt, dass sie in der Lage ist, eine Folie an einem Substrat anzuschweißen.

Unter Schweißen wird im Sinne der vorliegenden Patentanmeldung insbesondere das unlösbare Verbinden der Folie mit dem Substrat unter Anwendung von Wärme und/oder Druck verstanden.

Die Schweißvorrichtung dient dem Anschweißen einer Folie, bei der es sich insbesondere um eine spezielle Abziehfolie oder ein Abziehband handelt, das auch als Peeling-Band bezeichnet werden kann. Diese Folie ist insbesondere eine Kunststofffolie, beispielsweise eine PE, PA, PET Folie oder dergleichen.

Diese anzuschweißende Folie besitzt bevorzugt eine Heißkleberschicht, welche mittels der Schweißvorrichtung an dem Substrat angeklebt wird. Das Schweißen im Sinne der vorliegenden Patentanmeldung schließt somit neben einem Schweißen im oben definierten Sinne auch ein Heißkleben mit ein.

Erfindungsgemäß wird die Folie an einem Substrat angeschweißt. Grundsätzlich ist die Erfindung nicht auf bestimmte Arten von Substraten beschränkt, an denen die Folie angeschweißt werden kann. Bei einem Substrat kann es sich generell um eine Unterlage oder Grundlage für die anzuschweißende Folie handeln. Beispielsweise kann es sich bei dem Substrat um einen wie eingangs beschriebenen Wafer handeln. In anderer Ausgestaltung kann es sich bei dem Substrat um eine Folie, beispielsweise eine Schutzfolie handeln. In diesem Fall wird die erstgenannte Folie bevorzugt an diese weitere Folie angeschweißt.

Bevorzugt ist vorgesehen, dass es sich bei dem Substrat, an dem die Folie, insbesondere die Abziehfolie, angeschweißt wird, um einen Wafer handelt, bei dem zumindest an einer Oberfläche eine Folie, insbesondere eine Schutzfolie, aufgebracht ist. Dabei ist generell vorgesehen, dass der Wafer mit einer solchen Folie, insbesondere einer Schutzfolie, überzogen ist, wobei die Folie, insbesondere die Schutzfolie, haftend mit dem Wafer verbunden ist. Dabei kann die Folie, insbesondere die Schutzfolie, auf dem Wafer auflaminiert sein. Beim Laminieren handelt es sich insbesondere um ein stoffschlüssiges Fügeverfahren, mittels dessen die Folie an dem Wafer angeklebt wird.

Im Folgenden wird die Erfindung des Öfteren anhand eines Substrats beschrieben, bei dem es sich um einen Wafer mit auflaminierter Folie, insbesondere auflaminierter Schutzfolie handelt, wobei die Erfindung nicht auf diese konkrete Anwendungsform beschränkt ist. An ein solches Substrat wird nun eine weitere Folie, insbesondere eine Abziehfolie oder ein Abziehband, angeschweißt, wobei diese weitere Folie mittels der Schweißvorrichtung an die auf dem Wafer bereits befindliche Folie angeschweißt wird. Dies kann beispielsweise realisiert werden, indem die weitere Folie mittels der Schweißvorrichtung an die auf dem Wafer bereits befindliche Folie angeklebt, beispielsweise heißgeklebt wird.

Die Schweißvorrichtung wird nun im Folgenden näher erläutert, wobei die Schweißvorrichtung einen in besonderer Weise ausgestalteten Schweißkopf aufweist.

Der Schweißkopf weist zunächst einen beheizbaren Schweißstempel zum Erzeugen einer Schweißverbindung auf. Dabei ist die Erfindung nicht auf bestimmte Ausführungsformen für einen solchen Schweißstempel beschränkt. Ein Schweißstempel ist insbesondere ein Bauteil, das auf einer Seite erhaben ist, so dass es gegen die anzuschweißende Folie gedrückt werden kann. Ein solcher Schweißstempel stellt somit insbesondere eine Funktionsoberfläche bereit, mittels derer der Anschweißvorgang der Folie an dem Substrat erfolgt.

Dieser Schweißstempel ist beheizbar, was bedeutet, dass der Schweißstempel zum Erzeugen einer Schweißverbindung erwärmt werden kann oder aber Wärme erzeugt. Bevorzugt ist deshalb vorgesehen, dass der Schweißstempel mittels einer Heizquelle thermisch beheizt oder beheizbar ist, oder aber, dass der Schweißstempel als eine Heizquelle dient. Einige vorteilhafte, jedoch nicht ausschließliche Ausführungsbeispiele hierzu werden im weiteren Verlauf der Beschreibung näher erläutert.

Was den Schweißkopf an sich betrifft, so ist die vorliegende Erfindung nicht auf bestimmte Maße für den Schweißkopf beschränkt. Beispielsweise kann vorgesehen sein, dass der Schweißkopf eine Breite zwischen 80mm und 90mm aufweist. In einer bevorzugten Ausführungsform weist der Schweißkopf eine Breite von 86 mm auf. Weiterhin kann vorgesehen sein, dass der Schweißkopf eine Tiefe zwischen 50mm und 60mm aufweist. In einer bevorzugten Ausführungsform weist der Schweißkopf eine Tiefe von 53 mm auf. Die Tiefe des Schweißkopfs erstreckt sich dabei senkrecht zu dessen Breite.

Erfindungsgemäß ist weiterhin vorgesehen, dass der Schweißkopf benachbart zum Schweißstempel eine Kühleinrichtung zum Kühlen der Schweißverbindung oder einer Schweißzone aufweist.

Die benachbarte Anordnung bedeutet dabei, dass sich die Kühlvorrichtung in Bezug auf den Schweißstempel in der Nähe des Schweißstempels befindet, nämlich daneben vorgesehen ist. Dabei kann der Abstand zwischen dem Schweißstempel und der Kühlvorrichtung bevorzugt im Bereich einiger Millimeter liegen, beispielsweise im Bereich zwischen 2mm und 20mm, bevorzugt im Bereich zwischen 2mm und 10mm. Dieser Abstand gilt insbesondere im Hinblick auf die Anordnung bestimmter Kühldüsen der Kühleinrichtung, die weiter unten näher erläutert werden.

Die Kühleinrichtung hat insbesondere die Aufgabe, die mittels des Schweißstempels erzeugte Schweißverbindung oder eine Schweißzone abzukühlen. Zudem kann mit der Kühleinrichtung auch der Schweißstempel gekühlt werden. Es handelt sich somit insbesondere um eine aktive Kühlung zur Beschleunigung des Schweißprozesses durch schnelles Abkühlen zumindest der Schweißverbindung, beispielsweise einer Schweißnaht. Insbesondere kann auch vorgesehen sein, dass mittels der Kühlvorrichtung die Schweißzone abgekühlt wird. Bei der Schweißzone handelt es sich nicht nur um die eigentliche Schweißverbindung an sich, sondern auch um den die eigentliche Schweißverbindung, insbesondere unmittelbar, umgebenen Bereich, so dass eine Schweißzone von ihrer Dimensionierung her in der Regel etwas größer bemessen ist als die eigentliche Schweißverbindung.

Bei der erfindungsgemäßen Schweißvorrichtung ist insbesondere vorgesehen, dass der Schweißstempel die anzuschweißende Folie, beispielsweise eine Abziehfolie oder ein Abziehband, an das Substrat andrückt, was beispielsweise von unten erfolgen kann. Erfolgt das Andrücken von unten, reicht beispielsweise das Eigengewicht sowie die leichte Zugspannung von einer Quellrolle der anzuschweißenden Folie aus, um die Folie bei noch heißer und somit weicher Schweißverbindung, insbesondere Schweißnaht, bei der es sich insbesondere auch um eine Heißklebefläche handeln kann, davon wieder abzulösen. Dieses Problem konnte nunmehr gelöst werden, in dem die Schweißstelle, gegebenenfalls samt Schweißstempel nach Beendigung des eigentlichen Schweißvorgangs für einen bestimmten Zeitraum über die Kühleinrichtung gekühlt wird, damit die Schweißverbindung erkalten kann, der Kleber beispielsweise fest genug wird. Andere Peeling-Anlagen schweißen beispielsweise von oben. Dort tritt das Problem nicht auf, so dass die Schweißverbindung auch nicht aktiv gekühlt werden muss. In derartigen Fällen kühlt die Schweißverbindung bis zum Beginn des Abziehprozesses von selbst ausreichend ab.

Bevorzugt kann der Schweißstempel zumindest bereichsweise und zumindest dort, wo er mit der anzuschweißenden Folie direkt in Berührung kommt, mit einer Anti-Haft-Beschichtung versehen sein. Beispielsweise kann als Oberflächenbehandlung eine Antihaft-Beschichtung, wie sie auch bei Pfannen gewählt und eingesetzt wird, realisiert werden, beispielsweise eine Teflon-Beschichtung.

Bevorzugt ist weiterhin vorgesehen, dass der Schweißstempel mit einer Isolierabdeckung abgedeckt wird. Dabei ist diese Isolierabdeckung bevorzugt derart ausgestaltet, dass nur die Funktionsoberfläche des Schweißstempels durch diese nach außen hindurchragt.

Bevorzugt ist der Schweißstempel lösbar am Schweißkopf angeordnet. Das hat den Vorteil, dass der Schweißstempel von dem Schweißkopf auf einfache Weise abgebaut und an diesem angebaut werden kann, etwa zu Wartungszwecken, Reparaturzwecken oder generell zu Austauschzwecken. Im letztgenannten Fall kann insbesondere vorgesehen sein, dass bei der Schweißvorrichtung verschiedene Schweißstempel mit unterschiedlicher Kontur und/oder Breite zum Einsatz kommen können, etwa wenn unterschiedliche Folien, insbesondere unterschiedlich breite Folien mittels der Schweißvorrichtung an ein Substrat angeschweißt werden sollen/können. Auf diese Weise kann die Schweißvorrichtung, die ja in der Regel fest eingebaut und auch justiert wird, eingebaut bleiben, während nur der jeweils passende Schweißstempel ausgewählt und am Schweißkopf angeordnet wird. Beispielsweise kann vorgesehen sein, dass der Schweißstempel mittels Stecken, Klemmen, Schrauben oder dergleichen lösbar an dem Schweißkopf angeordnet ist, wobei die Erfindung nicht auf die genannten Beispiele beschränkt ist.

Bevorzugt weist die Schweißvorrichtung eine Heizeinrichtung zum Beheizen des Schweißstempels auf. Die Heizeinrichtung hat die Aufgabe, den Schweißstempel auf die für den Schweißvorgang erforderliche Schweißtemperatur zu bringen. Dabei ist insbesondere vorgesehen, dass die Heizeinrichtung zum variierbaren Heizen des Schweißstempels ausgebildet ist. Das bedeutet, dass über die Heizeinrichtung eine veränderliche Temperatur, und damit eine veränderliche Schweißtemperatur am/im Schweißstempel erzeugt beziehungsweise eingestellt werden kann. Dazu weist die Schweißvorrichtung bevorzugt einen entsprechenden Temperaturregler auf. Dieser Temperaturregler kann beispielsweise zur stufenlosen Einstellung der Temperatur am/im Schweißstempel ausgebildet sein. In anderer Ausgestaltung kann vorgesehen sein, dass durch den Temperaturregler eine Regelung der Temperatur in festgelegten Temperaturschritten, beispielsweise in Schritten von 10 Grad oder 20 Grad erfolgt. Zur Bestimmung der am/im Schweißstempel anliegenden Schweißtemperatur kann ein geeigneter Temperaturfühler vorgesehen sein.

Die Höhe der mit dem Schweißstempel zu erzeugenden Schweißtemperatur hängt insbesondere von dem Material der verwendeten Folie(n) ab. Folien aus den weiter oben genannten Kunststoffmaterialien PE, PA, PET beispielsweise haben eine Schmelztemperatur von 265 °C.

Deshalb ist bevorzugt vorgesehen, dass die Heizeinrichtung derart bereitgestellt ist, dass sie in der Lage ist, eine, insbesondere variierbare, Schweißtemperatur zu erzeugen, die unterhalb der Schmelztemperatur der anzuschweißenden Folie liegt. Bevorzugt ist vorgesehen, dass die Heizeinrichtung zum, insbesondere variierbaren, Heizen des Schweißstempels auf eine Temperatur zwischen 80°C und 250°C ausgebildet ist.

Grundsätzlich ist die Erfindung nicht auf bestimmte Typen von Heizeinrichtungen beschränkt. In einer bevorzugten Ausführungsform erfolgt die Beheizung des Schweißstempels elektrisch, insbesondere mittels eines Heizwiderstands, beispielsweise mittels einer Heizpatrone mit entsprechendem Heizwiderstand. Ein Heizwiderstand bezeichnet generell ein elektrisches Bauelement, das elektrische Energie in Wärme umwandelt. Bei einer Heizpatrone befindet sich dieses elektrische Bauelement in der Regel innerhalb eines Gehäuses. Die Wärme wird erzeugt, indem der Heizwiderstand, bei dem es sich um ein leitfähiges Material mit hohem elektrischem Widerstand handelt, von Strom durchflossen wird und sich dadurch erhitzt. Die Heizung kann beispielsweise erreicht werden, indem die Spannung auf 110 VAC erhöht werden kann. Dabei kann beispielsweise ein geeignetes Relais zum Einsatz kommen. Auch ist bevorzugt eine Möglichkeit vorgesehen, diese hohe Spannung zu überprüfen. Der Einsatz von Wechselspannung würde auch funktionieren, allerdings mit einer längeren Aufheizzeit. Auch könnte die Heizeinrichtung mit einem PID-Regler mit 230 V PWM betrieben werden.

Bevorzugt ist vorgesehen, dass der Schweißstempel eine möglichst kleine Auflagefläche aufweist. Nachfolgend werden einige bevorzugte Ausführungsbeispiele beschrieben, wie ein solcher Schweißstempel ausgebildet sein kann.

Der Schweißstempel weist eine gekrümmt verlaufende Kontur auf. Das heißt insbesondere, dass der Schweißstempel einen kurvig verlaufenden oder gekrümmten oder geschwungenen oder bogenförmigen Verlauf beziehungsweise eine solche Ausgestaltung hat.

Dabei ist bevorzugt vorgesehen, dass der Schweißstempel derart bereitgestellt ist, dass er in der Lage ist, mit seinem gekrümmten Verlauf beziehungsweise seiner gekrümmten Kontur insbesondere an eine Außenkante des Substrats angepasst zu sein, an dem die Folie angeschweißt wird beziehungsweise werden soll. Der gekrümmte Schweißstempel setzt in einem solchen Fall für den Schweißvorgang am Rand des Substrats, beispielsweise am Rand eines Wafers, auf. Bevorzugt entspricht die Krümmung des Schweißstempels dabei der Krümmung der Außenkante des Substrats, beispielsweise des Wafers. Dabei hängt der Grad der Krümmung, insbesondere der Krümmungsradius, insbesondere von der Größe und von der Kontur des Substrats ab.

Dies soll anhand eines Beispiels verdeutlicht werden. Handelt es sich bei dem Substrat um einen mit einer Schutzfolie überzogenen Wafer mit einem Durchmesser von 300mm, so setzt der gekrümmte beziehungsweise gebogene Schweißstempel am Rand des 300mm Wafers auf. Der Schweißstempel hat in einem solchen Fall einen Krümmungsradius von 150mm.

In weiterer Ausgestaltung weist der Schweißstempel bevorzugt eine Breite auf, die breiter ist als die Breite der anzuschweißenden Folie. Das bedeutet, dass der Schweißstempel breiter ist als die Breite der anzuschweißenden Folie, beispielsweise einer Abziehfolie oder einen Abziehbandes. Der Schweißstempel weist in Bezug auf die anzuschweißende Folie somit einen Überstand auf. Damit wird erreicht, dass die Ränder der anzuschweißenden Folie in jedem Fall überschweißt werden, damit die Folie in einem späteren Abziehvorgang nicht abreißen kann. Grundsätzlich ist die Erfindung nicht auf bestimmte Breiten für den Schweißstempel beschränkt. Vielmehr ergibt sich die erforderliche Breite in für den Fachmann ersichtlicher Weise aus der Breite der anzuschweißenden Folie. Dabei wird bevorzugt immer sichergestellt, dass der Schweißstempel im Vergleich zur anzuschweißenden Folie einen gewissen Überstand hat. Beispielsweise kann vorgesehen sein, dass der Schweißstempel eine Breite hat, die im Bereich zwischen 5mm und 10mm größer ist als die Breite der anzuschweißenden Folie. Hat die anzuschweißende Folie beispielsweise eine Breite von 40mm, so könnte der Schweißstempel eine Breite von 45mm aufweisen. Hat die anzuschweißende Folie beispielsweise eine Breite von 50mm, so könnte der Schweißstempel eine Breite zwischen 55mm und 60mm haben.

Bevorzugt weist der Schweißstempel eine äußere Oberfläche auf, die einer anzuschweißenden Folie zugewandt ist, wobei die äußere Oberfläche eine Rändelung aufweist. Unter Rändeln versteht man generell eine Art der Materialbearbeitung, bei der Muster in Werkstücke eingeprägt werden. Rändelungen sind deshalb insbesondere mittels Rändeln hergestellte Rillen im Schweißstempel. Durch diese Rillen, bei denen es sich beispielsweise um Längsrillen handelt, wird insbesondere erreicht, dass das Schweißmaterial, beispielsweise der Heißkleber, nicht aus der Schweißzone verdrängt wird, und dass eine Biegbarkeit der Schweißverbindung, beispielsweise der Schweißnaht gewährleistet ist. In anderer Ausgestaltung könnte die äußere Oberfläche auch eine nach innen gewölbte Kontur aufweisen.

Die Kühleinrichtung weist eine oder mehrere Kühldüsen für ein Kühlmedium auf. Bevorzugt sind mehre Kühldüsen vorgesehen, die über die Breite des Schweißkopfes verteilt angeordnet oder ausgebildet sind. Bevorzugt sind die Kühldüsen in Richtung des Schweißstempels, insbesondere in Richtung der Funktionsoberfläche des Schweißstempels, ausgerichtet. Beispielsweise kann es sich bei den Kühldüsen um Flachstrahldüsen handeln.

Zusätzlich kann die Kühleinrichtung eine Kühlplatte aufweisen. Schon durch die Wahl eines geeigneten Materials für die Kühlplatte kann eine Wärmeabfuhr aus dem Bereich der durch den Schweißstempel erzeugten Schweißverbindung oder der Schweißzone erreicht werden. In weiterer Ausgestaltung kann eine solche Kühlplatte auch eine Wärmetauscherfunktion aufweisen.

Grundsätzlich ist die Erfindung nicht auf bestimmte Typen von Kühlmedien beschränkt. Bevorzugt kommt als Kühlmedium jedoch Luft zum Einsatz, insbesondere in Form von Drucklust oder Pressluft.

Das Kühlmedium ist bevorzugt in einer geeigneten Speichereinrichtung, beispielsweise in einem Reservoir gespeichert. Die Speichereinrichtung ist über geeignete Verbindungen, etwa in Form von Kanälen oder Leitungen, die insbesondere flexibel ausgebildet sind, mit den Kühldüsen verbunden. Das Kühlmedium strömt aus der Speichereinrichtung über die Verbindungen zu den Kühldüsen und wird aus diesen in Richtung der durch den Schweißstempel erzeugten Schweißverbindung befördert, beispielsweise geblasen, so dass die erzeugte Schweißverbindung oder die Schweißzone beschleunigt abgekühlt werden.

Bevorzugt ist vorgesehen, dass der Schweißkopf der Schweißvorrichtung beweglich ist. Dazu weist die Schweißvorrichtung eine Antriebseinrichtung zum, insbesondere vertikalen, Verfahren des Schweißkopfs auf.

In weiterer Ausgestaltung oder zusätzlich ist bevorzugt vorgesehen, dass zum Zwecke eines Fluchtungsausgleichs der Schweißkopf insbesondere schwimmend an der Antriebseinrichtung gelagert ist. Mit der schwimmenden Lagerung, die dem Fachmann an sich bekannt ist, so dass es hinsichtlich von deren Funktionsweise keiner weitergehenden Erläuterungen bedarf, kann beispielsweise das Problem der inneren Verspannung vermieden werden.

Bevorzugt ist vorgesehen, dass die Antriebseinrichtung einen Hubzylinder aufweist, bei dem es sich insbesondere um einen linear verfahrbaren Hubzylinder handelt. Der Hubzylinder kann je nach Ausgestaltung hydraulisch, pneumatisch oder aber auch elektrisch betrieben werden. Der Hubzylinder dient dem Zweck, dass der Schweißkopf mit dem Schweißstempel in geeigneter Weise an die anzuschweißende Folie und das Substrat angedrückt werden kann. Dies wird im Zusammenhang mit den beiden anderen Erfindungsaspekten weiter unten noch in größerem Detail verdeutlicht. Insbesondere hat der Hubzylinder die Aufgabe, dass der Schweißkopf hochgefahren und mit einem definierten Druck an dem Substrat und der daran anzuschweißenden Folie angedrückt werden kann.

In einer weiteren Ausführungsform ist bevorzugt vorgesehen, dass die Antriebseinrichtung einen Druckregler aufweist. Bei einem Druckregler, der insbesondere als digitaler Druckregler ausgebildet sein kann, handelt es sich insbesondere um ein Bauelement, mit dessen Hilfe der Anpressdruck verändert werden kann. Grundsätzlich ist die Erfindung nicht auf bestimmte Drücke beschränkt, die mittels des Druckreglers realisiert werden können. Bevorzugt ist der Druckregler derart bereitgestellt, dass er in der Lage ist, dass der Schweißstempel des Schweißkopfes mit einem Druck von größer oder gleich 3 bar, insbesondere größer oder gleich 5 bar, bevorzugt größer oder gleich 6 bar gegen das Substrat mit der daran anzuschweißenden Folie angedrückt wird, so dass die Folie mit einem entsprechenden Druck an das Substrat angedrückt wird. Bevorzugt kann der Druckregler zur stufenlosen Einstellung eines geeigneten Anpressdrucks ausgebildet sein.

In weiterer Ausgestaltung ist bevorzugt vorgesehen, dass die Schweißvorrichtung wenigstens einen Zeitregler aufweist, mit dem die Dauer einer Schweißspanne und/oder einer Kühlspanne eingestellt werden kann und/oder mit dem der zeitliche Ablauf des Schweißens und des Kühlens eingestellt werden kann. Beispielsweise kann vorgesehen sein, dass der Zeitregler derart bereitgestellt ist, dass er in der Lage ist einzustellen, dass der Schweißvorgang für 3 Sekunden durchgeführt wird und/oder dass auf das Schweißen, insbesondere auf ein Schweißen für 3 Sekunden eine Kühlung von 3 Sekunden erfolgt. In diesem Fall wird über den Zeitregler eingestellt, dass die Schweißdauer 3 Sekunden beträgt und/oder das die Kühldauer 3 Sekunden beträgt. Natürlich sind auch andere Zeitspannen möglich, etwa für jeweils 10 Sekunden oder für jeweils 20 Sekunden. Es ist nicht unbedingt erforderlich, dass die Schweißdauern und Kühldauern jeweils identisch lang sind. Vielmehr können diese je nach Anwendungsfall und verwendeten Materialien variieren. Ebenso kann die jeweils erforderliche Zeitdauer für das Schweißen und Kühlen variieren. Bevorzugt ist vorgesehen, dass der wenigstens eine Zeitregler ausgebildet ist, die jeweils erforderliche Zeitdauer für das Schweißen und/oder das Kühlen individuell und insbesondere stufenlos einzustellen.

Gemäß einem zweiten Aspekt der Erfindung wird eine Bearbeitungsvorrichtung zum Anschweißen einer Folie an einem Substrat bereitgestellt, die eine Halteeinrichtung zur Aufnahme des Substrats aufweist. Die Bearbeitungsvorrichtung dient insbesondere dazu, ein Substrat, bei dem es sich insbesondere um ein wie weiter oben im Zusammenhang mit der Schweißvorrichtung beschriebenes Substrat handelt, zu behandeln oder zu bearbeiten. Die Bearbeitungsvorrichtung weist eine Halteeinrichtung auf, die beispielsweise Bestandteil eines Bearbeitungstischs sein kann oder als ein solcher Bearbeitungstisch ausgebildet ist. Während der Behandlung oder Bearbeitung des Substrats befindet sich dieses auf der Halteeinrichtung.

Handelt es sich bei dem Substrat um einen Wafer, so handelt es sich bei der Halteeinrichtung bevorzugt um einen so genannten Chuck. Ein Chuck stellt insbesondere eine Halterung dar, die beispielsweise an dem Bearbeitungstisch montiert ist, oder aber die einen solchen Bearbeitungstisch darstellt. Der Chuck nimmt den Wafer beispielsweise mittels eines erzeugten Vakuums auf.

Die Bearbeitungsvorrichtung ist erfindungsgemäß dadurch gekennzeichnet, dass sie eine wie vorstehend beschriebene erfindungsgemäße Schweißvorrichtung aufweist. Aus diesem Grund wird an dieser Stelle zur Vermeidung von Wiederholungen zunächst auf die Ausführungen zur erfindungsgemäßen Schweißvorrichtung weiter oben vollinhaltlich Bezug genommen und verwiesen.

Befindet sich auf der Halteeinrichtung ein Substrat in Form eines Wafers mit einer daran anlaminierten Folie, beispielsweise einer Schutzfolie, so kann diese Schutzfolie unter Zuhilfenahme einer wie vorstehende beschriebenen Schweißvorrichtung entfernt werden. Dazu wird mittels der Schweißvorrichtung eine weitere Folie, beispielsweise eine Abziehfolie, etwa ein Abziehband, an dem Substrat, insbesondere an der auf dem Wafer befindlichen Folie, in der wie weiter oben im Zusammenhang mit dem ersten Erfindungsaspekt geschilderten Weise angeschweißt.

Bevorzugt ist in einem solchen Fall vorgesehen, dass die Schweißvorrichtung unterhalb der Halteeinrichtung angeordnet ist.

Bevorzugt kann in einem solchen Fall in weiterer Ausgestaltung vorgesehen sein, dass die Bearbeitungseinrichtung über eine weitere Heizeinrichtung verfügt, die in einer Weise bereitgestellt ist, dass sie in der Lage ist, das Substrat, insbesondere die auf dem Wafer befindliche Folie, die abgezogen werden soll, vor Beginn der Folien-Abziehprozedur auf eine definierte Temperatur vorzuwärmen, beispielsweise auf eine Temperatur bis zu 80°C.

Damit die auf dem Wafer befindliche Folie, beispielsweise eine Schutzfolie, abgezogen werden kann, verfügt die Bearbeitungsvorrichtung neben den bereits beschriebenen Komponenten zusätzlich bevorzugt noch über weitere Komponenten. Das Anschweißen der Folie, insbesondere der Abziehfolie, an der auf dem Wafer befindlichen Folie, insbesondere der Schutzfolie, erfolgt über die weiter oben bereits beschriebene erfindungsgemäße Schweißvorrichtung, die insbesondere geheizt, gekühlt und druckgesteuert ist. Weiterhin ist bevorzugt eine Quellrolle vorgesehen, auf der sich die anzuschweißende Folie in Form einer Folienbahn befindet. Aufgewickelt wird diese Folie mit der daran befindlichen abgezogenen Folie am Ende des Abziehvorgangs bevorzugt auf einer Zielrolle. Der eigentliche Abziehvorgang findet bevorzugt unter Verwendung einer angetriebenen Abziehrolle oder Abziehwelle statt, die insbesondere mit einer Klemmrolle oder Klemmwelle zusammenwirkt, wobei diese Klemmrolle oder Klemmwelle gegen die Abziehrolle oder Abziehwelle gedrückt wird, was beispielsweise pneumatisch erfolgen kann. Alternativ kann es sich bei der Klemmrolle oder Klemmwelle auch um eine Umlenkrolle handeln. Die von der Quellrolle abgewickelte Folie wird der Abziehrolle oder Abziehwelle zugeführt, was beispielsweise über wenigstens eine weitere Umlenkrolle erfolgen kann, wodurch die Folie in eine parallele Ausrichtung zu der auf dem Wafer befindlichen Folie gebracht werden kann. Die Folie wird zwischen der Abziehrolle oder der Abziehwelle und der Klemmrolle oder der Klemmwelle, beziehungsweise einer entsprechenden Umlenkrolle eingeklemmt. Durch den Antrieb der Abziehrolle oder Abziehwelle wird die eingeklemmte Folie weiterbefördert und anschließend auf der Zielrolle aufgewickelt.

Gemäß einem dritten Aspekt der vorliegenden Erfindung wird ein Verfahren zum Anschweißen einer Folie an einem Substrat bereitgestellt. Dieses Verfahren wird unter Verwendung einer wie vorstehend beschriebenen erfindungsgemäßen Bearbeitungsvorrichtung durchgeführt, wobei die Bearbeitungsvorrichtung eine wie weiter oben beschriebene erfindungsgemäße Schweißvorrichtung aufweist. Aus diesem Grund wird zur Vermeidung von Wiederholungen zunächst vollumfänglich auf die beiden vorbeschriebenen Erfindungsaspekte Bezug genommen und verwiesen.

Das erfindungsgemäße Verfahren ist durch die folgenden Schritte gekennzeichnet:
In einem ersten Schritt wird eine anzuschweißende Folie zwischen die Schweißvorrichtung und das Substrat gebracht, wobei das Substrat in der wie weiter oben beschriebenen Weise ausgestaltet sein kann.

Anschließend wird die anzuschweißende Folie, bei der es sich um eine Abziehfolie oder ein Abziehband handeln kann, über die Schweißvorrichtung an das Substrat angedrückt. Dabei ist bevorzugt vorgesehen, dass die anzuschweißende Folie über die Schweißvorrichtung mit einem definierten Druck, wie weiter oben bereits beschrieben wurde, an das Substrat angedrückt wird. Bevorzugt ist das Substrat als Wafer ausgebildet, auf dem eine Folie, beispielsweise eine Schutzfolie, auflaminiert ist. In diesem Fall wird die anzuschweißende Folie über die Schweißvorrichtung an die auf dem Wafer befindliche Folie angedrückt.

In einem nächsten Schritt wird die anzuschweißende Folie über den Schweißstempel der Schweißvorrichtung für eine definierte Zeitdauer an dem Substrat angeschweißt, wobei eine Schweißverbindung zwischen der Folie und dem Substrat erzeugt wird. Dies erfolgt bevorzugt in der wie weiter oben bereits geschilderten Art und Weise.

Anschließend wird die angeschweißte Folie, insbesondere die Schweißverbindung oder eine Schweißzone, über die Kühlvorrichtung der Schweißvorrichtung für eine definierte Zeitdauer gekühlt. Dies erfolgt bevorzugt in der wie weiter oben bereits geschilderten Art und Weise.

Bevorzugt wird das Substrat vor dem Anschweißen der Folie auf eine definierte Temperatur vorgeheizt, was insbesondere in einer wie weiter oben bereits beschriebenen Art und Weise erfolgen kann.

In weiterer Ausgestaltung ist bevorzugt vorgesehen, dass die anzuschweißende Folie von unten gegen das Substrat angedrückt wird.

Nachdem die Folie, beispielsweise die Abziehfolie oder ein Abziehband, an dem Substrat, beispielsweise an einer auf einem Wafer befindlichen Folie, etwa einer Schutzfolie, angeschweißt worden ist, kann die auf dem Wafer befindliche Folie in einem nächsten Schritt abgezogen werden. Dabei wird die angeschweißte Folie in geeigneter Weise, so wie dies im Zusammenhang mit der Bearbeitungsvorrichtung weiter oben bereits erläutert worden ist, gezogen, so dass die an der Folie angeschweißte Folie, die sich zunächst auf dem Wafer befand, mit abgezogen wird. Durch den erfindungsgemäßen Schweißvorgang mittels Schweißung und gleich darauffolgender Kühlung ist auch bei einem Anschweißen der Folie von unten gegen das Substrat sichergestellt, dass die Schweißverbindung, oder aber die Schweißzone mit Beginn des eigentlichen Abziehvorgangs bereits so weit ausgekühlt ist, dass ein Abreißen der angeschweißten Folie von der auf dem Wafer befindlichen Folie nicht mehr möglich ist.

Die Erfindung wird nun anhand von Ausführungsbeispielen unter Bezugnahme auf die beiliegenden Zeichnungen näher erläutert. Es zeigen
- Figuren 1 bis 5: verschiedene Ansichten einer erfindungsgemäßen Schweißvorrichtung zum Anschweißen einer Folie;
- Figur 6: in schematischer Ansicht eine Bearbeitungsvorrichtung zum Anschweißen einer Folie an einem Substrat und zum anschließenden Abziehen einer auf dem Substrat befindlichen Folie; und
- Figuren 7 bis 12: in schematischer Ansicht den Anschweißvorgang und den anschließenden Abziehvorgang mittels der in Figur 6 dargestellten Bearbeitungsvorrichtung.

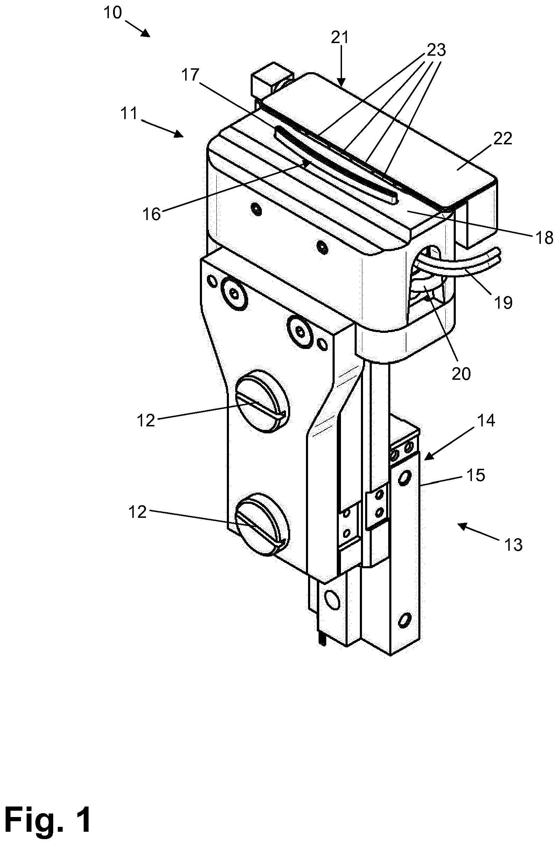

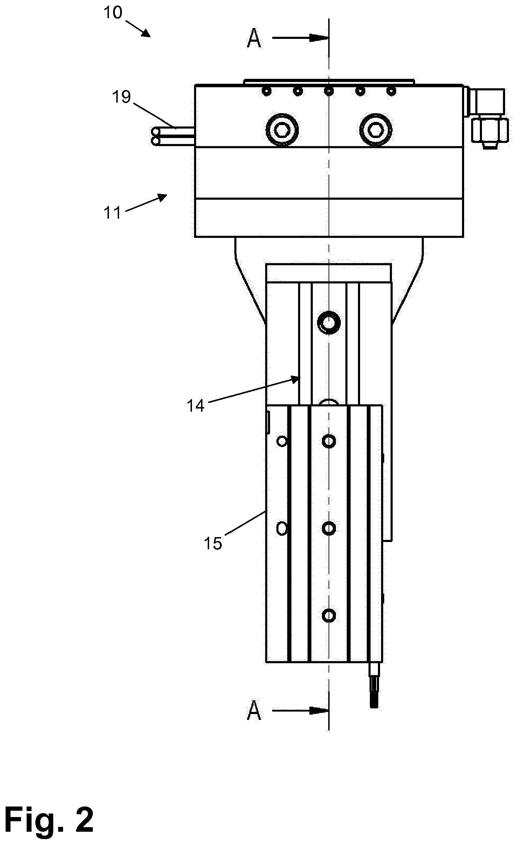

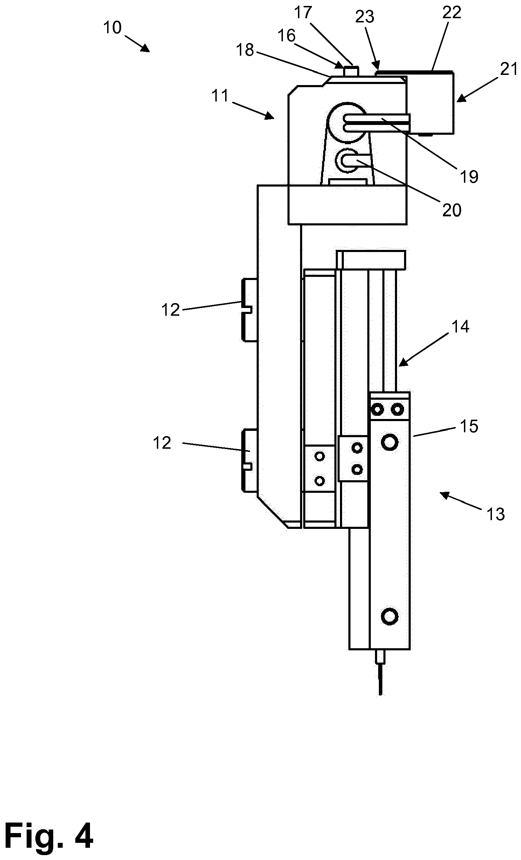

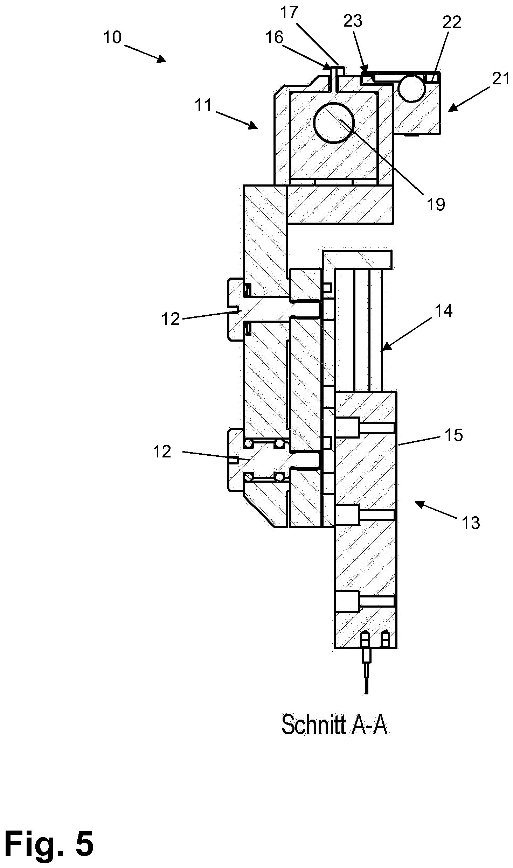

In den Figuren 1 bis 5 ist eine Schweißvorrichtung 10 dargestellt, mittels derer eine Folie in Form eines Abziehbands an einem Substrat angeschweißt werden kann. Bei dem Substrat handelt es sich um einen Wafer mit einem Durchmesser von 300mm, auf dem eine Folie, beispielsweise eine Schutzfolie, auflaminiert ist. Über die Schweißvorrichtung 10 soll eine Folie in Form des Abziehbands an einer auf dem Wafer befindlichen Folie in Form einer Schutzfolie angeschweißt werden.

Um dies zu bewerkstelligen, ist es bevorzugt, dass die Schweißvorrichtung 10 die anzuschweißende Folie mit einem definierten Druck an den Wafer andrücken kann. Weiterhin soll die Schweißvorrichtung 10 neben dem eigentlichen Schweißvorgang zusätzlich auch noch eine Kühlung der erzeugten Schweißverbindung ermöglichen.

Zu diesem Zweck weist die in den Figuren 1 bis 5 dargestellte Schweißvorrichtung 10 zunächst einen Schweißkopf 11 auf, der zum Zwecke eines Fluchtungsausgleichs über schwimmende Lagerungen 12 an einer Antriebseinrichtung 13 angeordnet ist. Über einen Hubzylinder 14 der Antriebseinrichtung 13 kann der Schweißkopf 11 vertikal verfahren werden. In dem gezeigten Ausführungsbeispiel ist dargestellt, dass der Schweißkopf 11 mittels des Hubzylinders 14 von unten gegen das Substrat angedrückt werden kann. Zum Einstellen eines geeigneten Anpressdrucks weist die Antriebseinrichtung 13 zudem einen Druckregler 15 auf. Der Druckregler 15 ist insbesondere derart ausgebildet, dass er je nach Anwendungsfall Anpressdrücke von 3bar, 5bar oder 6bar erzeugen kann.

Der über die schwimmenden Lagerungen 12 an der Antriebseinrichtung 13 angeordnete Schweißkopf 11 weist einen gekrümmt verlaufenden Schweißstempel 16 mit einer Funktionsoberfläche 17 auf, wobei die Funktionsoberfläche 17 mit der anzuschweißenden Folie in Berührung kommt. Die Funktionsoberfläche 17 weist eine oder mehrere Längsrillen auf, die beispielsweise mittels Rändelung erzeugt worden sind. Der Krümmungsradius des Schweißstempels 16 ist an den Durchmesser des Wafers angepasst und beträgt im vorliegenden Beispiel somit 150mm. Der Schweißstempel 16 mit seiner Funktionsoberfläche 17 ist durch eine Isolierabdeckung 18 abgedeckt. Die für den Schweißvorgang zu erzielende Schweißtemperatur im Schweißstempel 16 wird elektrisch unter Verwendung einer als Heizpatrone ausgebildeten Heizeinrichtung 19 realisiert. Die Schweißtemperatur wird unter Verwendung eines Temperaturfühlers 20 gemessen. Die Einstellung der gewünschten Schweißtemperatur kann über einen nicht dargestellten Temperaturregler erfolgen.

Benachbart zu dem Schweißstempel 16 ist eine Kühleinrichtung 21 vorgesehen. Die Kühleinrichtung 21 verfügt an einer Seite über eine Anzahl von Kühldüsen 23, über die Luft in Form von Druckluft abgegeben werden kann. Diese Luft stellt das Kühlmedium dar, über das die Kühlung vorgenommen wird. Zudem verfügt die Kühleinrichtung über eine Kühlplatte 22.

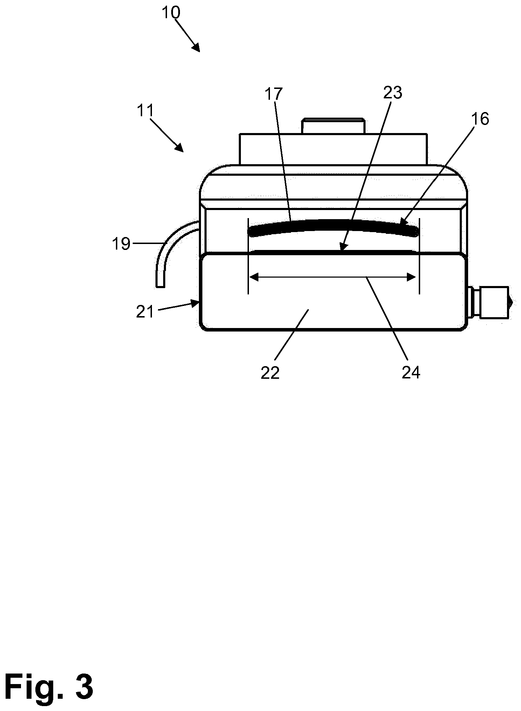

Damit das Anschweißen der Folie in Form des Abziehbands an der auf dem Wafer befindlichen Folie problemlos erfolgen kann, ist es bevorzugt, wenn die Ränder der anzuschweißenden Folie überschweißt werden. Aus diesem Grund ist die Breite 24 des Schweißstempels 16, wie insbesondere aus Figur 3 ersichtlich ist, größer als die Breite der anzuschweißenden Folie. Wenn die anzuschweißende Folie beispielsweise eine Breite von 40 mm aufweist, hat der Schweißstempel 16 bevorzugt eine Breite 24 von 45mm.

Nachfolgend wird die Funktionsweise der Schweißvorrichtung 10 anhand eines konkreten Beispiels beschrieben.

Die in den Figuren 1 bis 5 dargestellte Schweißvorrichtung 10 dient dem Anschweißen einer Folie, bei der es sich um ein spezielles Abziehband handelt, auf einer Kunststofffolie, die sich auf einem Wafer befindet. Dieses Abziehband besitzt beispielsweise eine Heißkleberschicht, welche mit dem Schweißstempel 16 auf die vom Wafer abzuziehende Folie am Waferrand angeklebt wird. Die Schweißvorrichtung 10 besteht im Kern aus dem gebogenen Schweißstempel 16, welcher am Rand des Wafers, der einen Durchmesser von 300mm aufweist, aufsetzt. Die Funktionsoberfläche 17 des Schweißstempels 16 ist längs gerillt, um den Heißkleber nicht aus der Schweißzone zu verdrängen, und um eine Biegbarkeit der Schweißverbindung zu gewährleisten.

Der Schweißstempel 16 drückt das Abziehband von unten nach oben auf die auf dem Wafer befindliche Folie, indem er mittels der Antriebseinrichtung 13 in die gewünschte Position gebracht wird. Nach dem eigentlichen Schweißvorgang, der beispielsweise etwa 3 Sekunden lang dauern kann, wird die Schweißverbindung oder die Schweißzone über die Kühleinrichtung 21 mit den Kühldüsen 23 für etwa 3 Sekunden lang mit Druckluft gekühlt, so dass der Kleber fest genug wird.

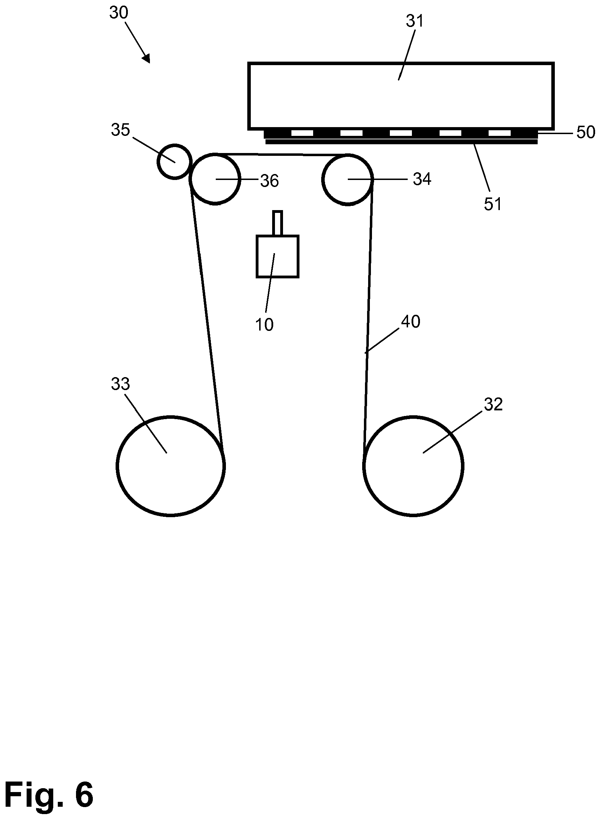

In Figur 6 ist eine Bearbeitungsvorrichtung 30 zum Bearbeiten eines Wafers 50 dargestellt, an dessen einer Oberfläche eine Folie 50 in Form einer Schutzfolie auflaminiert ist. Der Wafer 50 wird mittels Vakuum an einer Halteinrichtung 31 in Form eines Chucks gehalten.

Damit die auf dem Wafer 50 befindliche Folie 51 abgezogen werden kann, verfügt die Bearbeitungsvorrichtung 30 über eine Reihe weiterer Bauteile. Das Anschweißen einer Folie 40 in Form eines Abziehbandes an der auf dem Wafer 50 befindlichen Folie 51 erfolgt über eine Schweißvorrichtung 10, wie sie in den Figuren 1 bis 5 dargestellt und vorstehend beschrieben ist, wobei die Schweißvorrichtung 10 geheizt, gekühlt und druckgesteuert ist. Weiterhin ist eine Quellrolle 32 vorgesehen, auf der sich die anzuschweißende Folie 40 in Form einer Folienbahn befindet. Aufgewickelt wird diese Folie 40 mit der später daran befindlichen abgezogenen Folie 51 am Ende des Abziehvorgangs bevorzugt auf einer Zielrolle 33. Der eigentliche Abziehvorgang findet bevorzugt unter Verwendung einer angetriebenen Abziehrolle 35 statt, die mit einer Klemmrolle 36 zusammenwirkt, wobei die Klemmrolle 36 gegen die Abziehrolle 35 gedrückt wird, was beispielsweise pneumatisch erfolgen kann. Die von der Quellrolle 32 abgewickelte Folie 40 wird der Abziehrolle 35 zugeführt, was beispielsweise über wenigstens eine Umlenkrolle 34 erfolgen kann. Durch die Umlenkrolle 34 wird die Folie 40 in eine parallele oder annähernd parallele Ausrichtung zu der auf dem Wafer 50 befindlichen Folie 51 gebracht. Die Folie 40 wird zwischen der Abziehrolle 35 und der Klemmrolle 36 eingeklemmt. Durch den Antrieb der Abziehrolle 35 wird die eingeklemmte Folie 40 weiterbefördert und anschließend auf der Zielrolle 33 aufgewickelt.

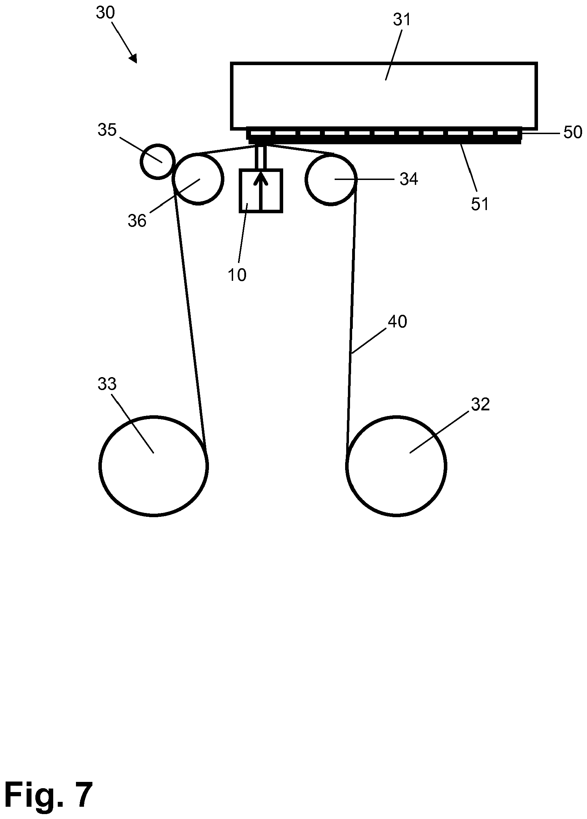

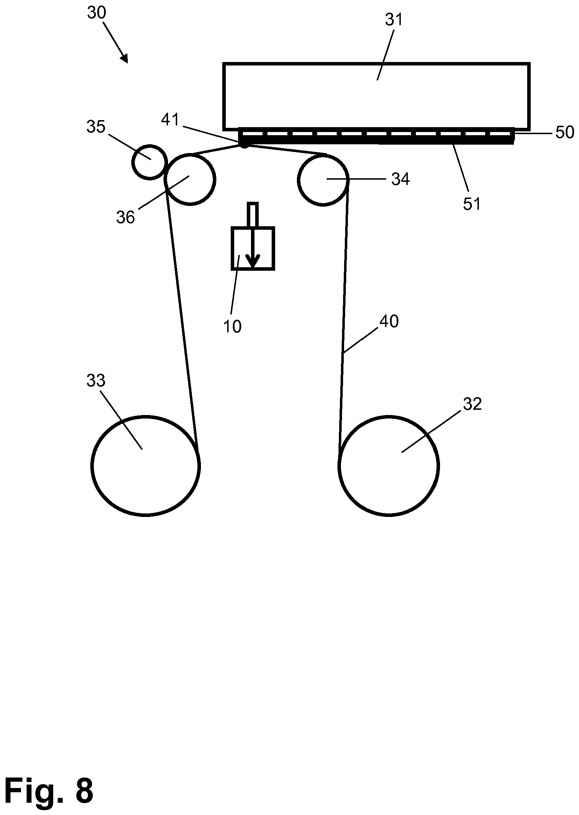

In den Figuren 7 und 8 ist dargestellt, wie die Folie 40 an die Folie 51 auf dem Wafer 50 angeschweißt wird. Dazu wird die Schweißvorrichtung 10 verwendet, zu deren Ausgestaltung und Funktionsweise auf die Figuren 1 bis 5 sowie die dazugehörige Beschreibung verwiesen wird. Die Schweißvorrichtung 10 wird von unten gegen die Folie 40 gefahren (Figur 7). Dabei ist die Position des der Schweißvorrichtung 10 ganz links am Rand des Wafers 50, so dass der gekrümmte Schweißstempel der Schweißvorrichtung 10 am Rand des Wafers 50 aufsetzt. Über die Schweißvorrichtung 10 wird die Folie 40 an die auf dem Wafer 50 befindliche Folie 51 angedrückt, was mittels eines definierten Drucks von beispielsweise 3bar oder 5bar oder 6 bar erfolgen kann. Anschließend erfolgt der eigentliche Schweißvorgang (Figur 8), bei dem es sich beispielsweise um einen Heißklebevorgang handeln kann. Dazu kann auch die Folie 51 zunächst auf eine definierte Temperatur vorgewärmt werden. Während des Schweißvorgangs wird zwischen der Folie 40 und der Folie 51 eine Schweißverbindung 41 erzeugt. Anschließend wird die Schweißvorrichtung 10 wieder nach unten gefahren.

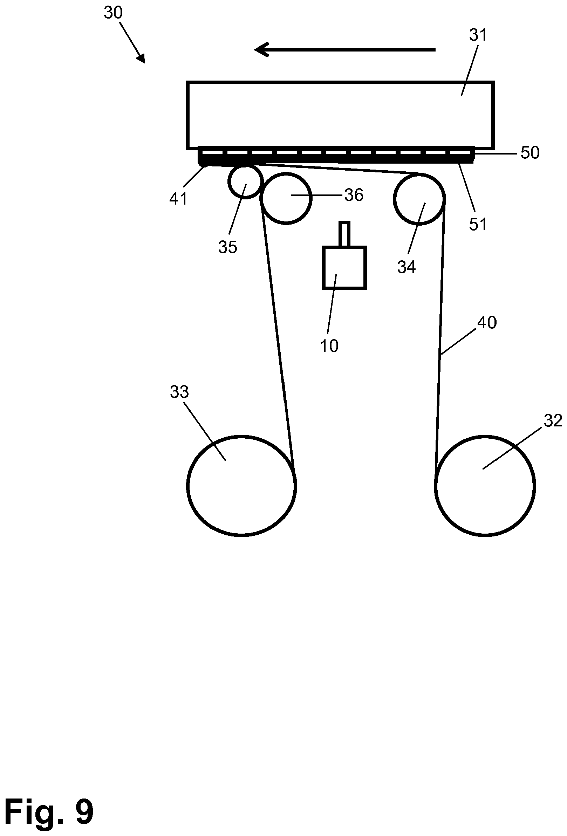

Anschließend wird die Folie 51 von dem Wafer abgezogen, was in den Figuren 9 bis 12 verdeutlicht ist. Dazu wird die Halteeinrichtung 31 in Bezug auf die verschiedenen Rollen der Bearbeitungsvorrichtung 50 verfahren, was durch einen entsprechenden Pfeil dargestellt ist. Entweder ist die Halteeinrichtung 31 fix und es bewegen sich die einzelnen Rollen entlang eines Verfahrwegs, oder aber umgekehrt. Sicherzustellen ist in jedem Fall, dass die angeschweißte Folie 40 während es gesamten Verfahrwegs nicht auf der Folie 51 ankleben darf.

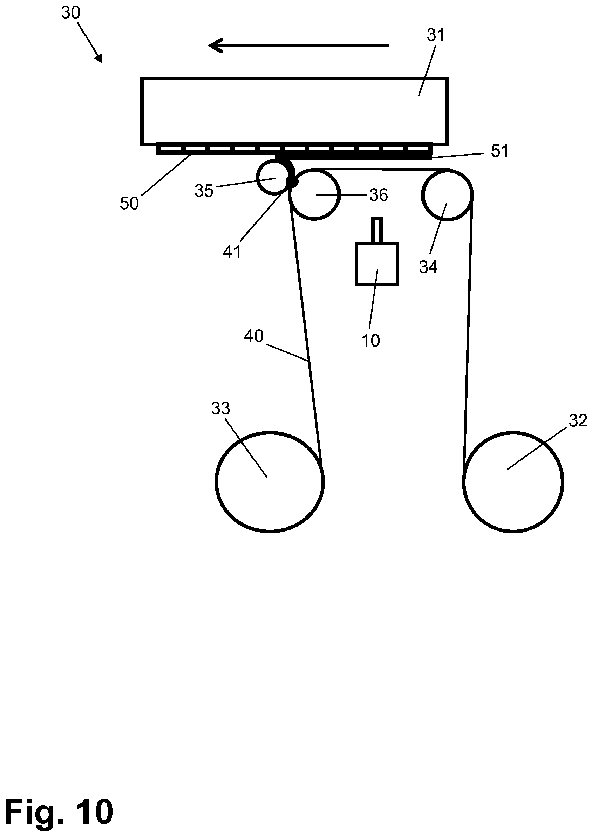

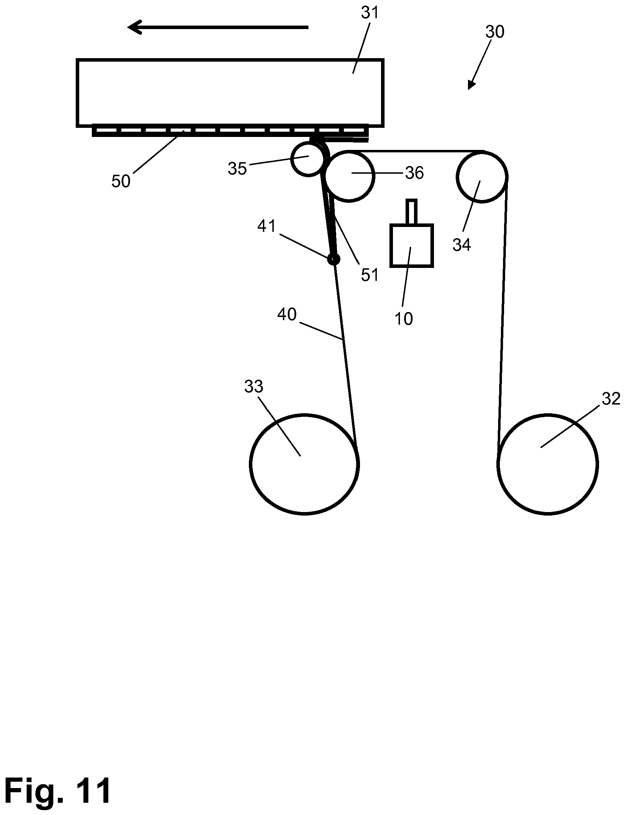

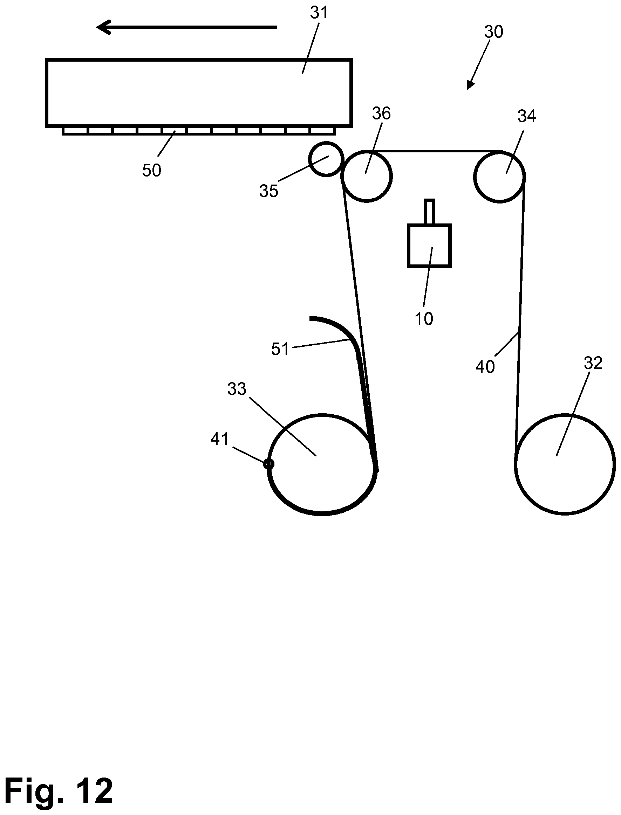

Während des Verfahrvorgangs wird die zwischen der Antriebsrolle 35 und der Klemmrolle 36 eingeklemmte Folie 40 zunächst in Richtung des Mittelpunkts des Wafers 50 gezogen. Gleichzeitig wird die Folie 40 durch die Antriebsrolle 35 und die Klemmrolle 36 nach unten in Richtung der Zielrolle 33 befördert und dort aufgewickelt. Aufgrund der festen Schweißverbindung 41 zwischen der Folie 40 und der Folie 51wird die Folie 51 zunächst am Rand des Wafers 50 abgelöst (Figur 9). Danach beginnt sich die Folie 51 in scharfem Winkel vom Wafer 50 abzulösen (Figur 10). Wegen der bestehenden Schweißverbindung 41 wird die Folie 51 zusammen mit der Folie 40 mittels der Antriebsrolle 35 und der Klemmrolle 36 in Richtung der Zielrolle 33 befördert (Figur 11). Im Endstadium des Abziehvorgangs (Figur 12) ist die Folie 51 vollständig vom Wafer 50 abgelöst und wird zusammen mit der Folie 41 auf der Zielrolle 33 aufgewickelt.

### Bezugszeichenliste

- 10: Schweißvorrichtung
- 11: Schweißkopf
- 12: Schwimmende Lagerung
- 13: Antriebseinrichtung
- 14: Hubzylinder
- 15: Druckregler
- 16: Schweißstempel
- 17: Funktionsoberfläche
- 18: Isolierabdeckung
- 19: Heizeinrichtung
- 20: Temperaturfühler
- 21: Kühleinrichtung
- 22: Kühlplatte
- 23: Kühldüse
- 24: Breite des Schweißstempels

- 30: Bearbeitungsvorrichtung
- 31: Halteeinrichtung
- 32: Quellrolle
- 33: Zielrolle
- 34: Umlenkrolle
- 35: Antriebsrolle
- 36: Klemmrolle
- 40: Folie (Abziehband)
- 41: Schweißverbindung

- 50: Wafer
- 51: Folie (Schutzfolie)

## Patentansprüche

1. Schweißvorrichtung (10) zum Anschweißen einer Folie (40) an einem Substrat (50, 51), mit einem Schweißkopf (11), wobei der Schweißkopf (11) einen beheizbaren Schweißstempel (16) zum Erzeugen einer Schweißverbindung aufweist, **dadurch gekennzeichnet, dass** der Schweißkopf ferner eine neben dem Schweißstempel (16) vorgesehene Kühleinrichtung (21) zum Kühlen der Schweißverbindung oder einer Schweißzone aufweist, dass der Schweißstempel (16) eine gekrümmt verlaufende Kontur aufweist, dass die gekrümmt verlaufende Kontur insbesondere an eine Außenkante eines Substrats (50, 51) angepasst ist, an das die Folie (40) angeschweißt werden soll und dass die Kühleinrichtung (21) eine oder mehrere Kühldüsen (23) für ein Kühlmedium aufweist.

2. Schweißvorrichtung nach Anspruch 1, **dadurch gekennzeichnet, dass** der Schweißstempel (16) lösbar am Schweißkopf (11) angeordnet ist.

3. Schweißvorrichtung nach Anspruch 1 oder 2, **dadurch gekennzeichnet, dass** diese eine Heizeinrichtung (19) zum Beheizen des Schweißstempels (16) aufweist und dass die Heizeinrichtung (19) zum, insbesondere variierbaren, Heizen des Schweißstempels (16) auf eine Temperatur zwischen 80°C und 250°C ausgebildet ist.

4. Schweißvorrichtung nach einem der Ansprüche 1 bis 3, **dadurch gekennzeichnet, dass** der Abstand zwischen dem Schweißstempel (16) und der Kühleinrichtung (21) im Bereich zwischen 2mm und 20mm, bevorzugt im Bereich zwischen 2mm und 10mm, liegt.

5. Schweißvorrichtung nach einem der Ansprüche 1 bis 4, **dadurch gekennzeichnet, dass** der Schweißstempel (16) eine Breite (24) aufweist, die breiter ist als die Breite der anzuschweißenden Folie (40), und/oder dass der Schweißstempel (16) eine Breite (24) von 45mm aufweist.

6. Schweißvorrichtung nach einem der Ansprüche 1 bis 5, **dadurch gekennzeichnet, dass** der Schweißstempel (16) eine äußere Oberfläche aufweist, die einer anzuschweißenden Folie (40) zugewandt ist und dass die äußere Oberfläche eine Rändelung aufweist.

7. Schweißvorrichtung nach einem der Ansprüche 1 bis 6, **dadurch gekennzeichnet, dass** die Schweißvorrichtung (10) eine Antriebseinrichtung (13) zum, insbesondere vertikalen, Verfahren des Schweißkopfs (11) aufweist und dass der Schweißkopf (11) insbesondere schwimmend (12) an der Antriebseinrichtung (13) gelagert ist.

8. Schweißvorrichtung nach Anspruch 7, **dadurch gekennzeichnet, dass** die Antriebseinrichtung (13) einen Hubzylinder (14) aufweist und/oder dass die Antriebseinrichtung (13) einen Druckregler (15) aufweist.

9. Bearbeitungsvorrichtung (30) zum Anschweißen einer Folie (40) an einem Substrat (50, 51), aufweisend eine Halteeinrichtung (31) zur Aufnahme des Substrats (50, 51), **dadurch gekennzeichnet, dass** die Bearbeitungsvorrichtung (30) eine Schweißvorrichtung (10) nach einem der Ansprüche 1 bis 8 aufweist.

10. Bearbeitungsvorrichtung nach Anspruch 9, **dadurch gekennzeichnet, dass** die Schweißvorrichtung (10) unterhalb der Halteeinrichtung (31) angeordnet ist.

11. Verfahren zum Anschweißen einer Folie (40) an einem Substrat (50, 51) unter Verwendung einer Bearbeitungsvorrichtung (30) nach Anspruch 9 oder 10, **gekennzeichnet durch** folgende Schritte:
Eine anzuschweißende Folie (40) wird zwischen die Schweißvorrichtung (10) und das Substrat (50, 51) gebracht;
Die anzuschweißende Folie (40) wird über die Schweißvorrichtung (10) an das Substrat (50, 51) angedrückt;
Die anzuschweißende Folie (40) wird über den Schweißstempel (16) der Schweißvorrichtung (10) für eine definierte Zeitdauer an dem Substrat (50, 51) angeschweißt, wobei eine Schweißverbindung (41) zwischen der Folie (40) und dem Substrat (50, 51) erzeugt wird;
Die angeschweißte Folie (40), insbesondere die Schweißverbindung (41) oder eine Schweißzone, wird über die Kühlvorrichtung (21) der Schweißvorrichtung (10) für eine definierte Zeitdauer gekühlt.

12. Verfahren nach Anspruch 11, **dadurch gekennzeichnet, dass** die anzuschweißende Folie (40) über die Schweißvorrichtung (10) mit einem definierten Druck an das Substrat (50, 51) angedrückt wird.

13. Verfahren nach einem der Ansprüche 11 oder 12, **dadurch gekennzeichnet, dass** das Substrat (50, 51) vor dem Anschweißen der Folie (40) auf eine definierte Temperatur vorgeheizt wird.

14. Verfahren nach einem der Ansprüche 11 bis 13, **dadurch gekennzeichnet, dass** die anzuschweißende Folie (40) von unten gegen das Substrat (50, 51) angedrückt wird.

## Claims

1. Welding device (10) for welding a film (40) on a substrate (50, 51), having a welding head (11), whereby the welding head (11) comprises a heatable welding die (16) for creating a welded connection, **characterized in that** the welding head further comprises a cooling device (21) next to the welding die (16) for cooling the welded connection or a welding zone, that the welding die (16) has a curved contour, that the curved contour in particular is adapted to an outer edge of a substrate (50, 51), to which the film (40) is to be welded on, and that the cooling device (21) comprises one ore more cooling nozzles (23) for a cooling medium.

2. Welding device according to claim 1, **characterized in that** the welding die (16) is detachably arranged on the welding head (11).

3. Welding device according to claim 1 or 2, **characterized in that** it comprises a heating device (19) for heating the welding die (16) and that the heating device (19) is provided for, in particular variable, heating of the welding die (16) to a temperature between 80 °C and 250 °C .

4. Welding device according to anyone of claims 1 to 3, **characterized in that** the distance between the welding die (16) and the cooling device (21) lies in the range between 2mm and 20mm, preferably in the range between 2mm and 10mm.

5. Welding device according to anyone of claims 1 to 4, **characterized in that** the welding die (16) has a width (24) which is wider than the width of the film (40) to be welded on, and/or that the welding die (16) has a width (24) of 45mm.

6. Welding device according to anyone of claims 1 to 5, **characterized in that** the welding die (16) has an outer surface which faces a film (40) to be welded on and that the outer surface comprises a knurling.

7. Welding device according to anyone of claims 1 to 6, **characterized in that** the welding device (10) comprises a drive device (13) for moving the welding head (11), in particular vertically, and that the welding head (11) is in particular floating (12) mounted on the drive device (13).

8. Welding device according to claim 7, **characterized in that** the drive device (13) comprises a lifting cylinder (14) and/or that the drive device (13) comprises a pressure regulator (15).

9. Processing device (30) for welding a film (40) on a substrate (50, 51), comprising a holding device (31) for receiving the substrate (50, 51), **characterized in that** the processing device (30) comprises a welding device (10) according to anyone of claims 1 to 8.

10. Processing device device according to claim 9, **characterized in that** the welding device (10) is arranged below the holding device (31).

11. Method for welding a film (40) on a substrate (50, 51) using a processing device (30) according to claim 9 or 10, **characterized by** the following steps:
a film (40) to be welded on is brought between the welding device (10) and the substrate (50, 51);
the film (40) to be welded on is pressed against the substrate (50, 51) via the welding device (10);
the film (40) to be welded on is welded on the substrate (50, 51) for a defined period of time via the welding die (16) of the welding device (10), with a welded joint (41) being generated between the film (40) and the substrate (50, 51);
the welded-on film (40), in particular the welded connection (41) or a welding zone, is cooled for a defined period of time by means the cooling device (21) of the welding device (10).

12. Method according to claim 11, **characterized in that** the film (40) to be welded on is pressed against the substrate (50, 51) with a defined pressure via the welding device (10).

13. Method according to anyone of claims 11 or 12, **characterized in that** the substrate (50, 51) is preheated to a defined temperature before the film (40) is welded on.

14. Method according to anyone of Claims 11 to 13, **characterized in that** the film (40) to be welded on is pressed against the substrate (50, 51) from below.

## Revendications

1. Dispositif de soudage (10) pour le soudage d'une feuille (40) sur un substrat (50, 51), avec une tête de soudage (11), dans lequel la tête de soudage (11) présente un poinçon de soudage (16) pouvant être chauffé, destiné à produire une liaison soudée, **caractérisé en ce que** la tête de soudage présente en outre un appareil de refroidissement (21) prévu à côté du poinçon de soudage (16), pour refroidir la liaison soudée ou une zone de soudage, que le poinçon de soudage (16) présente un contour s'étendant de manière courbée, que le contour s'étendant de manière courbée est en particulier adapté à un bord extérieur d'un substrat (50, 51), sur lequel la feuille (40) vise à être soudée et que l'appareil de refroidissement (21) présente une ou plusieurs buses de refroidissement (23) pour un réfrigérant.

2. Dispositif de soudage selon la revendication 1, **caractérisé en ce que** le poinçon de soudage (16) est disposé de manière détachable sur la tête de soudage (11).

3. Dispositif de soudage selon la revendication 1 ou 2, **caractérisé en ce que** celui-ci présente un appareil de chauffage (19) pour chauffer le poinçon de soudage (16) et que l'appareil de chauffage (19) est réalisé pour chauffer, en particulier de manière variable, le poinçon de soudage (16) à une température comprise entre 80°C et 250°C.

4. Dispositif de soudage selon l'une quelconque des revendications 1 à 3, **caractérisé en ce que** la distance entre le poinçon de soudage (16) et l'appareil de refroidissement (21) se situe dans la plage comprise entre 2 mm et 20 mm, de préférence dans la plage comprise entre 2 mm et 10 mm.

5. Dispositif de soudage selon l'une quelconque des revendications 1 à 4, **caractérisé en ce que** le poinçon de soudage (16) présente une largeur (24) qui est plus large que la largeur de la feuille (40) à souder, et/ou que le poinçon de soudage (16) présente une largeur (24) de 45 mm.

6. Dispositif de soudage selon l'une quelconque des revendications 1 à 5, **caractérisé en ce que** le poinçon de soudage (16) présente une surface extérieure qui est tournée vers une feuille (40) à souder et que la surface extérieure présente un moletage.

7. Dispositif de soudage selon l'une quelconque des revendications 1 à 6, **caractérisé en ce que** le dispositif de soudage (10) présente un appareil d'entraînement (13) pour le déplacement, en particulier vertical, de la tête de soudage (11) et que la tête de soudage (11) est montée en particulier de manière flottante (12) sur l'appareil d'entraînement (13).

8. Dispositif de soudage selon la revendication 7, **caractérisé en ce que** l'appareil d'entraînement (13) présente un cylindre de levage (14) et/ou que l'appareil d'entraînement (13) présente un régulateur de pression (15).

9. Dispositif de traitement (30) pour le soudage d'une feuille (40) sur un substrat (50, 51), présentant un appareil de retenue (31) destiné à recevoir le substrat (50, 51), **caractérisé en ce que** le dispositif de traitement (30) présente un dispositif de soudage (10) selon l'une quelconque des revendications 1 à 8.

10. Dispositif de traitement selon la revendication 9, **caractérisé en ce que** le dispositif de soudage (10) est disposé au-dessous de l'appareil de retenue (31).

11. Procédé pour souder une feuille (40) sur un substrat (50, 51) au moyen d'un dispositif de traitement (30) selon la revendication 9 ou 10, **caractérisé par** les étapes suivantes :
une feuille (40) à souder est amenée entre le dispositif de soudage (10) et le substrat (50, 51) ;
la feuille (40) à souder est pressée sur le substrat (50, 51) par l'intermédiaire du dispositif de soudage (10) ;
la feuille (40) à souder est soudée sur le substrat (50, 51) pendant une durée définie par l'intermédiaire du poinçon de soudage (16) du dispositif de soudage (10), dans lequel une liaison soudée (41) est produite entre la feuille (40) et le substrat (50, 51) ;
la feuille (40) soudée, en particulier la liaison soudée (41) ou une zone de soudage, est refroidie pendant une durée définie par l'intermédiaire du dispositif de refroidissement (21) du dispositif de soudage (10).

12. Procédé selon la revendication 11, **caractérisé en ce que** la feuille (40) à souder est pressée sur le substrat (50, 51) avec une pression définie par l'intermédiaire du dispositif de soudage (10).

13. Procédé selon l'une quelconque des revendications 11 ou 12, **caractérisé en ce que** le substrat (50, 51) est préchauffé à une température définie avant le soudage de la feuille (40).

14. Procédé selon l'une quelconque des revendications 11 à 13, **caractérisé en ce que** la feuille (40) à souder est pressée par le bas contre le substrat (50, 51).
